# EUROPEAN PATENT APPLICATION

(11) **EP 2 234 231 A1**
(43) Date of publication of application: **29.09.2010**
(21) Application number: 08853475.5
(22) Date of filing: 20.11.2008
(51) Int. Cl.: H02G 3/16, B60R 16/02, H05K 5/02

(54) **ELECTRIC CONNECTION BOX**

(30) Priority: 26.11.2007 JP 2007305030
(71) Applicant: The Furukawa Electric Co., Ltd., Tokyo 100-8322 (JP); Furukawa Automotive Systems Inc., Inukami-gun, Shiga 522-0242 (JP)
(72) Inventor: AOKI, Osamu, Inukami-gun Shiga 522-0242 (JP); HOSODA, Michie, Inukami-gun Shiga 522-0242 (JP); SAWAKI, Yoshiaki, Inukami-gun Shiga 522-0242 (JP)
(74) Representative: Kirschner, Klaus Dieter
(86) International application number: PCT/JP2008/003421
(87) International publication number: WO 2009/069271

(57) **Abstract**

An electric connection box for an automobile effectively prevents entry of water into the box and allows water entered the box to be easily discharged. The electric connection box has a base block (11) having a component-mounting surface (20) on which electric components such as relays (30) are mounted, and also has an upper cover (10) for covering the electric components. The component-mounting surface (20) is located above the lower end of a peripheral section (34) of the upper cover (10). On the outer periphery of the base block (11) is formed a first peripheral wall (31) fitting to the peripheral section (34) of the upper cover (10). The first peripheral wall (31) is located inside the peripheral section (34) of the upper cover (10). The upper end of the first peripheral wall (31) is located above the lower end of the peripheral section (34) of the upper cover (10). The component-mounting surface (20) is located above the upper end of the first peripheral wall (31).

## Description

### [Technical Field]

The present invention relates to an electric connection box for an automobile which has a plurality of electric components mounted therein.

### [Background Art]

Generally, an electric connection box to be mounted within an engine room of an automobile is known as the type having electric components like relays or fuses disposed on a base block, the electric components being covered with an upper cover. Also, the electric connection box is known as another type having a wire harness connected to the electric components in such a manner as to be drawn from the underside of the base block, the wire harness being covered with a lower cover.

Under the configurations of the above-mentioned electric connection boxes, however, rainwater enters the interiors of the electric connection boxes and reaches a component-mounting surface on which the electric components are mounted on the base blocks, such that the contacts of the connectors of the electric components become wet to cause their malfunctions. So as to prevent the problems, a prior art patent document 1 discloses an electric connection box that provides a predetermined gap between a case body and a rear cover so as to prevent the capillary action of water caused by the invasion of the water from a gap of the rear cover.
Patent Document 1: Japanese Patent Laid-Open No.2001-238328

According to the configuration of the prior art patent document 1, however, the rainwater invaded from the gap reaches the component-mounting surface of the base block under the water pressure or vibrations caused by the running of the automobile, thereby causing the contacts of the connectors of the electric components to be wet. Therefore, the conventional electric connection box should be improved to ensure the prevention of the malfunctions of the electric components mounted therein.

### [Disclosure]

### [Technical Problem]

Accordingly, the present invention has been made in an effort to solve the above problems occurring in the prior arts, and it is an object of the present invention to provide an electric connection box that is capable of preventing the invasion of water to the interior thereof and also easily discharging the water to the outside, even if the water enters forcibly the interior thereof.

### [Technical Solution]

To achieve the above object, according to the present invention, there is provided an electric connection box including: a base block having a component-mounting surface on which electric components are mounted; and an upper cover for covering the electric components, wherein the component-mounting surface is located above the lower end of a peripheral section of the upper cover. Accordingly, even though the rainwater is invaded from a lower end (a fitting gap) formed on the peripheral section of the upper cover, it is difficult for the rainwater to reach the component-mounting surface being located higher than the lower end of the peripheral section of the upper cover. As a result, the wetting of the electric components can be effectively prevented.

According to the present invention, the base block forms a first peripheral wall fitting to the peripheral section of the upper cover on the outer periphery thereof. The first peripheral wall is located inside the peripheral section of the upper cover. The first peripheral wall is located at the upper end thereof above the lower end of the peripheral section of the upper cover. Also, the component-mounting surface is located above the upper end of the first peripheral wall.

Otherwise, the electric connection box may have another configuration as described below. That is, the electric connection box has a lower cover fitting to the base block. The lower cover forms a first peripheral wall fitting to the peripheral section of the upper cover on the outer periphery thereof. The first peripheral wall is located inside the peripheral section of the upper cover. The first peripheral wall is located at the upper end thereof above the lower end of the peripheral section of the upper cover. Also, the component-mounting surface is located above the upper end of the first peripheral wall.

Under the above configuration, even if rainwater is invaded from the fitting gap, the water should be passed over the first peripheral wall so as to reach the component-mounting surface. Therefore, the electric connection box of the present invention can effectively prevent the electric components from being wet.

According to the present invention, the electric connection box desirably has the following configurations. That is, the upper cover forms a downwardly extending second peripheral wall inside the peripheral section thereof. The second peripheral wall is located inside the first peripheral wall, and the component-mounting surface is located above the lower end of the second peripheral wall.

Under the above configuration, when rainwater is invaded from the fitting gap, the water can reach the component-mounting surface on the conditions where the water is passed over the upper end of the first peripheral wall, is passed over the lower end of the second peripheral wall, and is moved upwardly toward the component-mounting surface. The arrival of the water on the component-mounting surface can be more effectively prevented by means of the effect of Labyrinth seal, thereby completely protecting the electric components from the water.

According to the present invention, desirably, the component-mounting surface has a water-discharging hole formed along the peripheral section thereof, so as to downwardly discharge the water invaded from a gap of a fitting portion of the upper cover.

Under the above configuration, even though water is invaded to the component-mounting surface, the water is dropped through the water-discharging hole. Accordingly, the water is difficult to reach the electric components and their connectors, thereby realizing more effective water-proof results.

According to the present invention, desirably, the component-mounting surface has a groove formed on a portion thereof, so as to induce the water invaded thereon to the water-discharging hole.

Under the above configuration, even though water reaches the component-mounting surface, the water can be rapidly induced through the groove to the water-discharging hole. Accordingly, the wetting of the electric components can be effectively prevented.

According to the present invention, desirably, the component-mounting surface is slantly formed.

Under the above configuration, even though water reaches the component-mounting surface, the water does not stay on the component-mounting surface for a long time. Accordingly, the wetting of the electric components can be effectively prevented.

### [Description of Drawings]

FIG.1 is a perspective view showing the outer appearance of an electric connection box according to a first embodiment of the present invention.
FIG.2 is an exploded perspective view showing the electric connection box according to the first embodiment of the present invention.
FIG.3 is a partly sectional view showing the surrounding area of a fitting portion between a base block and an upper cover in the electric connection box according to the first embodiment of the present invention.
FIG.4 is a perspective view showing the main parts of the base block of an electric connection box according to a second embodiment of the present invention.
FIG.5 is a partly sectional view showing the surrounding area of a fitting portion between a lower cover and an upper cover in an electric connection box according to a third embodiment of the present invention.

### *Explanations on the reference numerals of the main parts in the drawings*

- 10:: upper cover
- 11:: base block
- 12:: lower cover
- 15:: electric connection box
- 20:: component-mounting surface
- 21:: guide wall
- 22, 23:: locking hook
- 24, 25:: locking fitting part
- 30:: relay (electric component)
- 31:: first peripheral wall
- 32:: second peripheral wall
- 33:: water-discharging hole
- 34:: peripheral section of upper cover
- 43:: fitting gap
- 50:: drain groove

### [Mode for Invention]

Hereinafter, an explanation on an electric connection box according to the preferred embodiments of the present invention will be given with reference to the attached drawings.

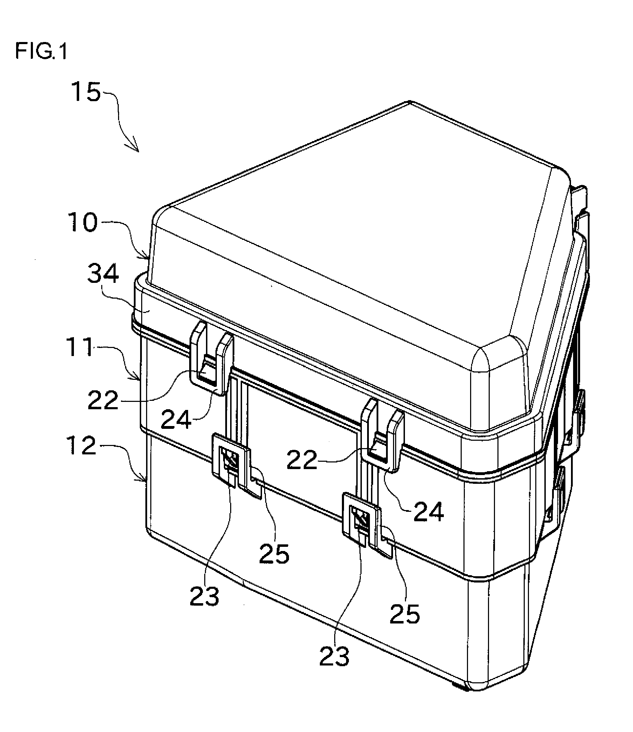

FIG.1 is a perspective view showing the outer appearance of an electric connection box according to a first embodiment of the present invention.

As shown in FIG.1, an electric connection box 15 is disposed at the upper portion of an engine room of an automobile, which includes an upper cover 10, a base block 11 and a lower cover 12. The base block 11 has a generally trapezoidal shape when viewed on the plane.

A plurality of locking hooks 22 is mounted along the upper end portion of the base block 11, and also, a plurality of locking hooks 23 is mounted along the lower end portion of the base block 11. On the other hand, a plurality of locking fitting parts 24 is disposed along the lower end portion of the upper cover 10 in corresponding relation with the plurality of locking hooks 22, and also, a plurality of locking fitting parts 25 is disposed along the upper end portion of the lower cover 12 in corresponding relation with the plurality of locking hooks 23. Thus, the upper cover 10 and the lower cover 12 are fixed with respect to the base block 11 when the plurality of locking hooks 22 and 23 are coupled with the plurality of locking fitting parts 24 and 25.

The plurality of locking fitting parts 24 is disposed along a peripheral section on the lower end of the upper cover 10. Each locking fitting part 24 can be taken by a user's finger at the lower end thereof, and thus, a force caused from the locking hook 22 is applied to the locking fitting part 24 in a crossing direction thereto, such that the locking fitting relation between the locking hook 22 and the locking fitting part 24 is released. Next, the upper cover 10 is opened to perform the maintenance of the electric components. In the same manner as the above, a force caused by the user's finger is applied to each locking fitting part 25, so that the lower cover 12 can be separated from the base block 11.

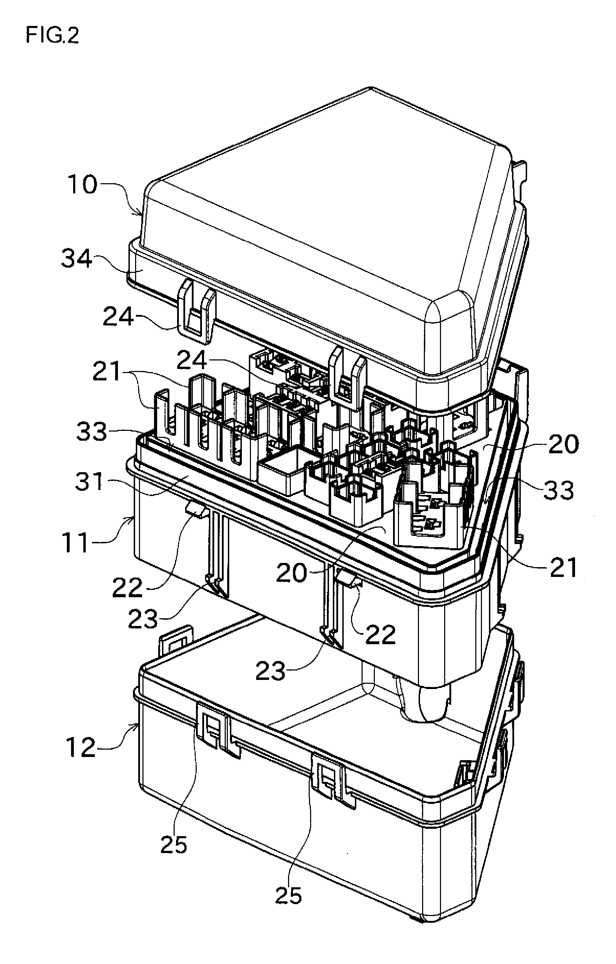

FIG.2 is an exploded perspective view showing the electric connection box according to the first embodiment of the present invention. As shown in FIG.2, the base block 11 has a component-mounting surface 20 horizontally formed thereon, on which electric components like a plurality of relays are mounted. The component-mounting surface 20 is formed on the entire top surface of the base block 11.

The base block 11 further has a plurality of guide walls 21 erected vertically from the component-mounting surface 20. Under the above configuration, the electric components like the relays are mounted on the component-mounting surface 20 at the inside of the guide walls 21. The electric components are not shown in FIG.2.

The base block 11 has a water-discharging hole 33 formed along the peripheral section of the component-mounting surface 20, and the water-discharging hole 33 is extended elongated along the peripheral section of the base block 11. The water dropped from the water-discharging hole 33 flows downwardly to the lower cover 12 and is finally discharged to the outside of the electric connection box 15.

Around the peripheral section (on the outside of the water-discharging hole 33) of the component-mounting surface 20, a first peripheral wall 31 is disposed on the top surface of the base block 11. The first peripheral wall 31 is formed elongated along the water-discharging hole 33. The first peripheral wall 31 is protudedly formed upwardly and at the same time it is forcibly fitted to the inside of the peripheral section 34 formed on the lower portion of the upper cover 10.

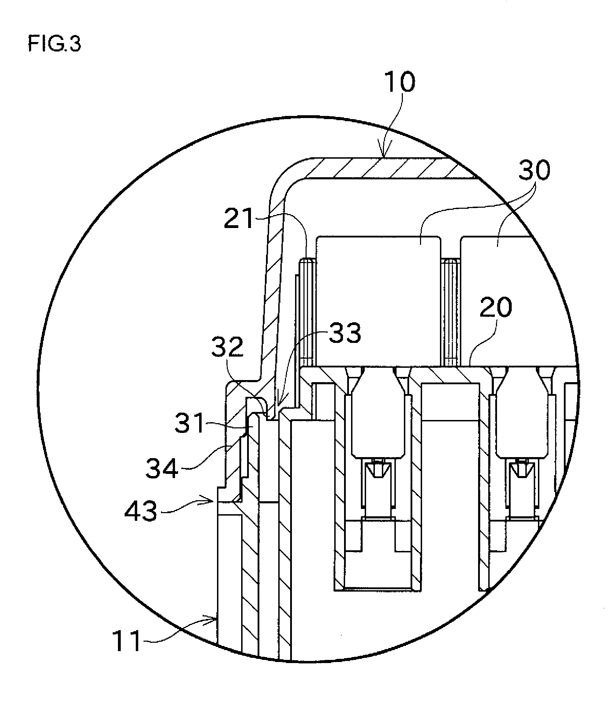

FIG.3 is a partly sectional view showing the surrounding area of a fitting portion between a base block and an upper cover in the electric connection box according to the first embodiment of the present invention. As shown in FIG.3, the relays (electric components) 30 are mounted on the component-mounting surface 20, in the interior of the upper cover 10.

As shown in FIG.3, the peripheral section 34 of the upper cover 10 is formed extended downwardly over the component-mounting surface 20. In other words, the component-mounting surface 20 is disposed above the lower end of the peripheral section 30 of the upper cover 10. Also, the first peripheral wall 31, which is fitted at the inside thereof to the peripheral section 30 of the upper cover 1, is located at the upper end thereof above the lower end of the peripheral section 34 of the upper cover 10.

The upper cover 10 has a downwardly extending second peripheral wall 32 located inside of the peripheral section 34 thereof. The second peripheral wall 32 is located inside the first peripheral wall 31 and under the component-mounting surface 20 at the lower end thereof.

The second peripheral wall 32 is formed elongated along the first peripheral wall 31. Also, the opened portion of the water-discharging hole 33 formed on the base block 11 faces the lower portion of the second peripheral wall 32.

Under the above-mentioned configuration, water like rainwater may enter a gap (fitting gap 43) formed at the coupling portion between the upper cover 10 and the base block 11. So as to allow the water to reach the component-mounting surface 20, the water is passed over the upper end of the first peripheral wall 31 and is then passed over the lower end of the second peripheral wall 32 disposed at the inside of the first peripheral wall 31. After that, the water should be moved upwardly up to the height of the component-mounting surface 20, without any drop to the water-discharging hole 33. Accordingly, it is really hard to move the water up to the component-mounting surface 20 and to cause the relays 30 to become wet. According to the present invention, therefore, good water-proof effects can be achieved.

The water, which fails to enter the inside by means of the second peripheral wall 32, is instantly discharged downwardly through the water-discharging hole 33. As a result, it is more difficult for the water to reach the component-mounting surface 20. Accordingly, the prevention of the wetting of the electric components like the relays 30 can be absolutely ensured.

As mentioned above, the electric connection box 15 according to the first embodiment of the present invention includes the base block 11 having the component-mounting surface 20 on which the electric components like the relays 30 are mounted and the upper cover 10 adapted to cover the electric components. The component-mounting surface 20 is located above the lower end of the peripheral section 34 of the upper cover 10.

Under the above configuration, even though the rainwater is invaded from the gap (the fitting gap 43) formed at the coupling portion between the upper cover 10 and the base block 11, it is difficult for the rainwater to reach the component-mounting surface 20. Accordingly, the wetting of the electric components like the relays 30 can be prevented.

According to the present invention, further, the first peripheral wall 31 is located around the base block 11, which is adapted to be fitted to the peripheral section 34 of the upper cover 10. The first peripheral wall 31 is located inside the peripheral section 34 of the upper cover 10 and is also located at the upper end thereof above the lower end of the peripheral section 34 of the upper cover 10. Moreover, the component-mounting surface 20 is located above the upper end of the first peripheral wall 31.

Under the above configuration, even if water is invaded from the fitting gap 43, the water should be passed over the first peripheral wall 31 so as to reach the component-mounting surface 20. Therefore, the invasion of the water to the interior of the box can be effectively prevented, and further, the wetting of the electric components like the relays 30 can be prevented.

Also, the upper cover 10 has the downwardly extending second peripheral wall 32 located inside the peripheral section 34 thereof. The second peripheral wall 32 is located inside the first peripheral wall 31, and the component-mounting surface 20 is located above the lower end of the second peripheral wall 32.

Under the above-mentioned configuration, when water like rainwater is invaded from the fitting gap 43, the water can reach the component-mounting surface 20 on the conditions where the water is passed over the upper end of the first peripheral wall 31, is passed over the lower end of the second peripheral wall 32 disposed at the inside of the first peripheral wall 31, and is moved upwardly up to the height of the component-mounting surface 20. The arrival of the water on the component-mounting surface 20 can be more effectively prevented by means of the effect of Labyrinth seal.

According to the electric connection box 15 of the present invention, further, the water-discharging hole 33 is formed around the peripheral area of the component-mounting surface 20, so as to discharge the water invaded from the gap (the fitting gap 43) of the upper cover 10 to the outside.

The water, which has entered the component-mounting surface 20 from the outside, is dropped to the water-discharging hole 33, thereby preventing the electric components from being wet. Moreover, even though the water enters the component-mounting surface 20, the water can be discharged by means of the water-discharging hole 33.

On the other hand, in the preferred embodiment of the present invention, no spare fuses are mounted inside the upper cover 10, which permits the component-mounting surface 20 to be located higher by a corresponding height to the mounting space of the spare fuses. Accordingly, the lower end of the peripheral section 34 of the upper cover 10 is located under the component-mounting surface 20.

In other words, if it is desired to keep the spare components in the upper cover 10, there is a need to prepare a predetermined distance between the upper end of the upper cover 10 and the component-mounting surface 20 within the upper cover 10. Thus, the component-mounting surface 20 should be located near the lower end of the upper cover 10. If the peripheral section 34 of the upper cover 10 is extended downwardly over the component-mounting surface 20, the upper cover 10 becomes large in depth, such that the mounting positions of the locking hooks 22 and the locking fitting parts 24 should be moved downwardly, thereby making it difficult to insert the user's hand within the small engine room and to contact the user's finger with the locking fitting parts 24.

In view of this, according to the present invention, the spare fuses are not kept in the interior of the upper cover 10, so that the component-mounting surface 20 of the base block 11 can be located to a relatively high position. Therefore, even if the lower end of the peripheral section 34 of the upper cover 10 is located under the component-mounting surface 20, the depth of the upper cover 10 is not large, so that the mounting positions of the locking hooks 22 and the locking fitting parts 24 should not be moved downwardly. Accordingly, the user's hand can be easily contacted with the locking fitting parts 24 so as to open the upper cover 10, thereby easily performing the maintenance of the electric components.

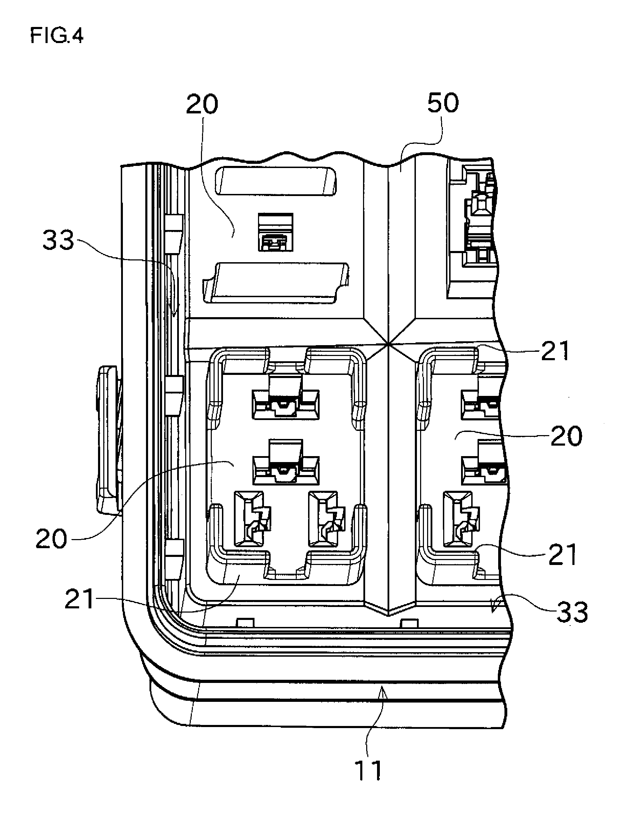

Hereinafter, another preferred embodiment of the present invention will be described with reference to FIG.4. FIG.4 is a perspective view showing the main parts of the base block of an electric connection box according to a second embodiment of the present invention.

According to the second embodiment of the present invention, as shown in FIG.4, a drain groove 50 having a 'V'-shaped section is formed on the component-mounting surface 20 located on the top surface of the base block 11. The drain groove 50 is slantly formed to a height reducing from the center of the component-mounting surface 20 toward the peripheral section (the water-discharging hole 33) thereof. As a result, the water existing in the drain groove 50 is induced to the water-discharging hole 33.

Under the above-mentioned configuration of the second embodiment of the present invention, even when the water enters the component-mounting surface 20, the water is rapidly sent to the water-discharging hole 33 through the drain groove 50, thereby effectively preventing the electric components like the relays 30 from being wet.

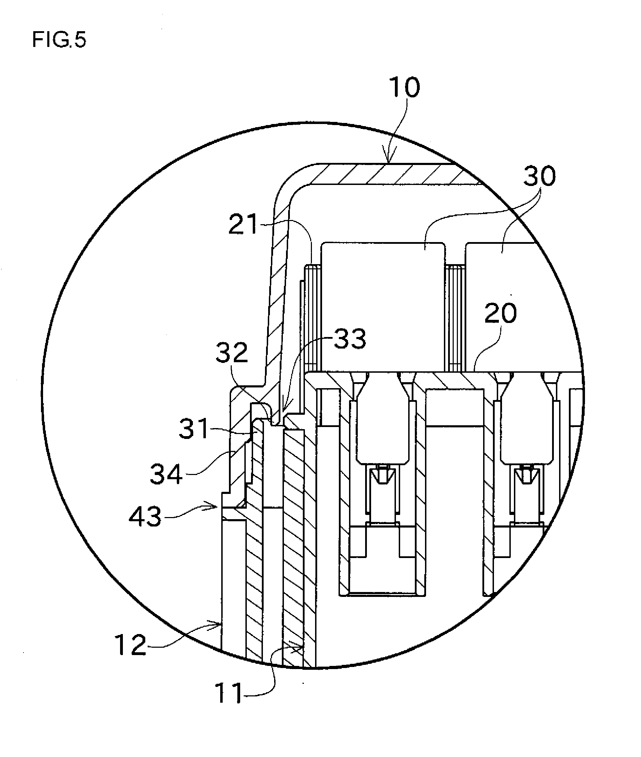

While the present invention has been described with reference to the particular illustrative embodiments, it may be modified into, for example, various embodiments having the following configurations. In the preferred embodiments of the present invention, the upper cover 10 is fitted to the base block 11. In stead of this, for example, the upper cover 10 may be fitted to the lower cover 12, as shown in FIG.5. In this case, the first peripheral wall 31 fitting to the upper cover 10 is located on the lower cover 12, not on the base block 11, and the base block 11 is fitted inside the lower cover 12. In this configuration, of course, the entry of water like rainwater may be effectively prevented.

In the first and second embodiments of the present invention, the mounting of the lower cover 12 can be avoided. In view of protecting the wire harness located under the base block, however, the lower cover 12 is desirably mounted.

The drain groove 50 as shown in FIG.4 may be freely changed to one having an arch-shaped section. Further, the drain groove 50 slantly formed to a height reducing toward the water-discharging hole 33 may be changed to a horizontally formed drain groove. That is, when the drain groove 50 does not have any slope, the drain groove 50 is formed in such a manner as to avoid the positions where the electric components like the relays 30 are mounted. In this case, water gathers on the drain groove 50, thereby effectively preventing the electric components from being wet. In view of rapidly discharging the water, while the water does not stay on the component-mounting surface 20, the drain groove 50 is desirably formed slantly toward the water-discharging hole 33, as shown in FIG.4.

The base block 11 may be formed on which a slantly formed component-mounting surface is mounted. For example, the base block 11 mounts a convexly curved component-mounting surface on the top portion thereof thereon. In this case, even though the water reaches the component-mounting surface, the water does not stay thereon and rapidly flows to the peripheral section thereof, thereby being discharged through the water-discharging hole 33. On the other hand, the drain groove may be formed on the slantly formed component-mounting surface, and in this case, more effective draining results can be expected.

## Claims

1. An electric connection box comprising:
a base block having a component-mounting surface on which electric components are mounted; and
an upper cover for covering the electric components, wherein the component-mounting surface is located above the lower end of a peripheral section of the upper cover.

2. The electric connection box mold according to claim 1, wherein the base block forms a first peripheral wall fitting to the peripheral section of the upper cover on the outer periphery thereof, the first peripheral wall being located inside the peripheral section of the upper cover and being located at the upper end thereof above the lower end of the peripheral section of the upper cover, and the component-mounting surface is located above the upper end of the first peripheral wall.

3. The electric connection box according to claim 2, wherein the upper cover forms a downwardly extending second peripheral wall inside the peripheral section thereof, the second peripheral wall being located inside the first peripheral wall, and the component-mounting surface is located above the lower end of the second peripheral wall.

4. The electric connection box according to claim 1, further comprising a lower cover fitting to the base block, the lower cover forming a first peripheral wall fitting to the peripheral section of the upper cover on the outer periphery thereof, the first peripheral wall being located inside the peripheral section of the upper cover and being located at the upper end thereof above the lower end of the peripheral section of the upper cover, and the component-mounting surface is located above the upper end of the first peripheral wall.

5. The electric connection box according to claim 4, wherein the upper cover forms a downwardly extending second peripheral wall inside the peripheral section thereof, the second peripheral wall being located inside the first peripheral wall, and the component-mounting surface is located above the lower end of the second peripheral wall.

6. The electric connection box according to any one of claims 1 to 5, wherein the component-mounting surface has a water-discharging hole formed along the peripheral section thereof, so as to downwardly discharge the water invaded from a gap of a fitting portion of the upper cover.

7. The electric connection box according to claim 6, wherein the component-mounting surface has a groove formed on a portion thereof, so as to induce the water invaded thereon to the water-discharging hole.

8. The electric connection box according to claim 1, wherein the component-mounting surface is slantly formed.
